(19)

Europäisches Patentamt
European Patent Office
Office européen des brevets

(11) EP 4 095 538 A1

(12) **EUROPEAN PATENT APPLICATION**

(43) Date of publication:
**30.11.2022 Bulletin 2022/48**

(21) Application number: **21176101.0**

(22) Date of filing: **26.05.2021**

(51) International Patent Classification (IPC):
*G01R 33/24* (2006.01)  *G01R 33/07* (2006.01)
*G01R 33/387* (2006.01)  *G01R 33/389* (2006.01)
*G01R 33/565* (2006.01)  *G01R 33/58* (2006.01)
*G01R 33/02* (2006.01)

(52) Cooperative Patent Classification (CPC):
**G01R 33/24; G01R 33/0035; G01R 33/0206;
G01R 33/072; G01R 33/075; G01R 33/387;
G01R 33/389; G01R 33/56581; G01R 33/58;**
G01R 33/56563; G01R 33/56572

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicant: **Skope Magnetic Resonance
Technologies AG
8044 Zürich (CH)**

(72) Inventors:
• **BRUNNER, David
8044 Zürich (CH)**
• **GROSS, Simon
8044 Zürich (CH)**

(74) Representative: **Schmauder & Partner AG
Patent- & Markenanwälte VSP
Zwängiweg 7
8038 Zürich (CH)**

(54) **A MAGNETIC RESONANCE (MR) ASSEMBLY COMPRISING PROBES FOR MEASURING MAGNETIC FIELD, A METHOD OF OPERATING THE SAME, AN MRI APPARATUS COMPRISING THE SAME AND A METHOD OF OPERATING THE MRI APPARATUS**

(57)     A magnetic resonance (MR) assembly (2) comprising a main magnetic field magnet providing a main magnetic field ($B_0$) along a main field axis (A) within a volume of interest (4), gradient coils (6) for generating gradient magnetic fields superimposed onto the main magnetic field according to an MR acquisition sequence or MR service sequence, a plurality of magnetic field probes (8, 8a, 8b, 8c, 8d; 10, 10a, 10b, 10c), each positioned within said volume of interest, each magnetic field probe generating a probe signal, and a controller (12) connected to each field probe for receiving and processing respective probe signals. To improve and extend the assembly's operation, said plurality of magnetic field probes comprises a plurality of at least three MR probes (8, 8a, 8b, 8c, 8d), each one of said MR probes comprising an MR active substance (14), means (18, 20, 22) for pulsed MR excitation of said substance and means (18, 20, 22) for receiving from said substance an MR probe signal indicative of a local magnetic field magnitude, and at least one Hall probe (10, 10a, 10b, 10c), each one of said Hall probes comprising a Hall element (26) having a respective Hall axis (H), means (28) for generating an electric current within said Hall element and means (30) for receiving a Hall probe signal indicative of a local magnetic field vector component along said Hall axis.

Fig. 1a

**Description**

Field of the Invention

The present invention generally relates to a magnetic resonance (MR) assembly. Moreover, the invention relates to a method of operating the MR assembly, to a magnetic resonance imaging (MRI) apparatus comprising the MR assembly and to a method of operating the MRI apparatus.

Description of the prior art

In MR imaging, magnetic fields are used to manipulate nuclear magnetic resonance signals. Typically, time-varying magnetic gradient fields in multiple directions are superimposed onto a constant, homogeneous main magnetic field to create spatial modulations of the local magnetic field across the object under examination. The homogeneous field is usually generated by a superconductive electromagnet. The gradient fields are usually generated by applying specifically shaped current waveforms to a plurality of gradient and shim coils. MR excitation is achieved by application of a radio frequency (RF) field at the so-called Larmor frequency, according to a pre-defined pulse sequence, followed by RF signal detection. The acquired RF signal is then converted to image or spectral information by means of known methods. The above series of events is also referred to as "MR sequence".

Ideally, the main magnetic field and the gradient fields would follow precisely defined spatial and temporal patterns. However, electromagnetic coupling among the various coils as well as between the coils and other components of the apparatus distorts the ideal field patterns and time courses. Timing imperfections in control electronics have similar effects. Spatial and temporal variations of the magnetic field can also arise from temperature changes in the apparatus, which frequently occur during operation. Another source of field variation is the magnetic susceptibility of the subject or object under examination. It causes added field contributions, which can vary over time, e.g., due to physiological motion like breathing. MR images and spectra acquired in the presence of such field deviations typical exhibit errors, distortions, artifacts, or signal losses.

Considering the above, it is clear that carrying out high quality MRI will require accurate information about the spatio-temporal electromagnetic field evolution in "real time", i.e., during the various steps of the MR sequence and calibration of the MR scanner.

It has long been recognized that the spatiotemporal low-frequency magnetic field evolution in a volume of interest can be determined by means of an array comprising a plurality of magnetic field detectors, also called "magnetic field probes", arranged within or in the vicinity of the volume of interest [Barmet et al. ISMRM 2009 p.780]. Such arrangements, which are occasionally referred to as "dynamic magnetic field cameras", allow for observing the spatiotemporal low-frequency magnetic field evolution.

One promising approach for magnetic field cameras relies on arrays of probes which exploit the magnetic field dependence of magnetic resonance signals, particularly of nuclear magnetic resonance (NMR) signals [DeZanche et al. MRM 60:176-186 (2008); Sipilä et al. ISMRM 2010 p.781]. In particular, such arrangements use MR probes operating in a pulsed NMR mode. As already disclosed in EP 1 582 886 A1, arrays of MR probes can be used as a monitoring setup during execution of an MRI sequence. The magnetic field information thus obtained is used for an improved reconstruction of the images and/or for adjusting the MR sequence so as to account for imperfections in the magnetic field behavior.

Magnetic field probes based on the observation of an MR signal of a suitable probe substance, henceforth called "MR probes", offer high sensitivity, accuracy and bandwidth at high magnetic fields [De Zanche N, Barmet C, Nordmeyer-Massner JA, Pruessmann KP. NMR probes for measuring magnetic fields and field dynamics in MR systems. Magn Reson Med 60(1), 176-186, 2008]. Further, the phase of the MR probe signal obtained therefrom represents the field integral over time, which is of special interest in applications of such sensors in MRI and NMR. Therefore, the directly measured temporal field integrals do not suffer from error/noise accumulation as it is the case when integrating the signal of a magnetic field sensor of other types such as a Hall device. However, during the acquisition of images and spectra with the host MRI system, wherein the term "host" shall denote the MRI system into which the MR probes are built in, high power RF pulses are applied, which will affect the signal retrieved from the MR probes. For this reason, the MR probes are typically operated on a different or shifted MR resonance than the host MRI setup and thus operate in a different RF frequency band. In the case of nuclear magnetic resonance (NMR), the probes typically exploit a different nuclear species than that being examined with the host MRI setup. The separation of frequency bands allows separating said two concurrently performed measurements by frequency selective excitations, digital and analog filtering as well as frequency separation, as long as the systems behave substantially linearly and none of the two systems emit substantially interfering signals at the frequency of operation of the other system. While a number of measures and provisions such as filters and trapping circuits in the receive chains of the MR probes (see e.g. EP 2515132 A1) and shields (see e.g. EP 2708908 A1) can be taken to avoid that high power RF signals coupled from the host system into the MR probe receive lines destroy, saturate or modulate the receivers of the MR probes, strong and broadband noise emitted by the power amplifier's output increases the noise floor of the field sensors and hence lowers critically their precision. A possible solution to these problems is based on active noise cancellation, as disclosed in WO 2016/184760 A1.

As already mentioned, MR probes are not the only type of magnetic field probe employed in MRI settings. In particular, magnetic field sensors exploiting the Hall effect, which will henceforth be called "Hall probes", are widely used in many types of technical applications. Hall probes generally comprise an electrically conducting plate through which an electric current is driven in a direction within the plate's plane. In the presence of a magnetic field having a component perpendicular to the plane, the Hall effect results in a voltage which is orthogonal to the current and proportional to the magnetic field perpendicular to the plate's plane.

In spite of their cost-effective implementation, small form factor, good sensitivity, robustness to saturation at high field and ability to detect the magnetic field in a particular direction, i.e., to act as vector magnetometer, Hall probes have not been widely used in MRI applications. This may be attributed to the fact that presently available Hall probes have a lower sensitivity than MR probes. Further disadvantages of Hall probes are their offsets, general temporal drift, their temperature dependent drift behavior and the presence of through axis effects, i.e., of magnetic field components colinear to the Hall plate generating a finite Hall voltage (Planar Hall Effect) *[see Sanfilippo2011]*. Nevertheless, the use of Hall probes is described in US 2018 / 0292502 A1, which discloses an approach of spatiotemporal magnetic field monitoring during an MRI scan which relies on magnetic field sensors exploiting the Hall effect.

Summary of the Invention

It is thus an object of the present invention to provide an improved magnetic resonance (MR) assembly. In particular, such an assembly shall overcome the limitations and disadvantages of presently known systems.

According to one aspect of the invention (claim 1), a magnetic resonance (MR) assembly comprises:

- a main magnetic field magnet providing a main magnetic field along a main field axis (A) within a volume of interest,
- gradient coils for generating gradient magnetic fields superimposed onto the main magnetic field according to an MR acquisition sequence or MR service sequence,
- a plurality of magnetic field probes, each positioned within said volume of interest, each magnetic field probe generating a probe signal,
- a controller connected to each field probe for receiving and processing respective probe signals,

the plurality of magnetic field probes comprising:

- a plurality of at least three MR probes, each one of said MR probes comprising an MR active substance, means for pulsed MR excitation of said substance and means for receiving from said substance an MR probe signal indicative of a local magnetic field magnitude, and
- at least one Hall probe, each one of said Hall probes comprising a Hall element having a respective Hall axis (H), means for generating an electric current within said Hall element and means for receiving a Hall probe signal indicative of a local magnetic field vector component along said Hall axis.

According to another aspect of the invention (claim 10), there is provided a method of operating an MR assembly as defined above, wherein a magnetic field distribution in the volume of interest is determined from values of local magnetic field magnitude obtained from said MR probes and from values of local magnetic field vector components obtained from said at least one Hall probes.

According to a further aspect of the invention (claim 16), a magnetic resonance imaging (MRI) apparatus comprises

- an MR assembly as defined above,
- an RF receiver coil for acquiring object MR signals from an object located within the volume of interest,

wherein the controller is further connected to the RF receiver coil, and wherein the controller is configured for reconstructing images from a combination of the object MR signals and from the probe signals.

According to yet another aspect of the invention (claim 17), a method of operating an MRI apparatus as defined above comprises:

- generating gradient magnetic fields superimposed onto the main magnetic field according to an MR acquisition sequence,
- acquiring probe signals from said magnetic field probes,

- acquiring object MR signals from an object located within the volume of interest,
- reconstructing of images from a combination of the object MR signals and from the probe signals.

Advantageous embodiments are defined in the dependent claims and described further below.

The term "MR acquisition sequence" shall be understood as a sequence of events as generally known for MR imaging and spectroscopy. In a typical MR acquisition sequence, time-varying magnetic gradient fields in multiple directions are superimposed onto the constant, homogeneous main magnetic field to create spatial modulations of the local magnetic field across the object under examination. The homogeneous field is usually generated by a superconductive electromagnet, whereas the gradient fields are usually generated by applying specifically shaped current waveforms to a plurality of gradient coils. MR excitation is achieved by application of an appropriately pulsed radio frequency (RF) field at the so-called Larmor frequency, and the resulting RF signal is then converted to image or spectral information by means of known methods.

The term "MR service sequence" will generally be used for a sequence of events as above which, however, does not necessarily comprise the acquisition of MR image or spectral information from the subject. Service sequences are executed e.g., during installation or servicing of an MR scanner, but also in conjunction with an MR acquisition sequence (as a pre-, interleaved or post sequence). Such sequences are aimed at measuring delays, coupling and distortions, e.g., gradient delays, eddy currents, cross-coupling that will be apparent in the actual MR acquisition sequence. The results of such measurements are then employed to correct the MR data by means of feed-forward (preemphasis), feed-back or post-correction or to determine correct operation of the scanner. Typical examples of installation and servicing sequences are calibration of gradient gain, pre-emphasis and crosscoupling, transmitter calibrations. Calibration sequences are typically performed before scanning or interleaved with the MR acquisition sequence. Examples are center frequency detection, EPI phase correction, UTE gradient delay calibration, echo-phase correction etc.

The above-mentioned controller is to be understood as a device which is operatively connected to each field probe so as to be able to receive from each field probe a respective probe signal. Moreover, the controller is configured to process the received probe signals. In this context, the term "process" will generally include basic operations such as amplification, filtering, voltage-to-current and current-to-voltage conversion and analog-to-digital conversion. Some of these operations may be implemented in a controller component located in close proximity to the respective field probe, whereas some other operations may be implemented in an external controller component. Finally, said controller may comprise connections to the MR assembly for synchronization and applying corrections.

It should be emphasized that the term "MR probe" refers to a magnetic field probe which relies on MR as operating principle. Accordingly, such a probe will generally comprise an MR active substance, means for pulsed MR excitation of said substance and means for receiving from said substance an MR probe signal indicative of a local magnetic field magnitude. In the present context, where MR probes are used within an MR assembly or MRI apparatus, a strong main magnetic field is available which enables the MR phenomena exploited by the MR probes and by the MR assembly/apparatus. Depending on the embodiment, i.e., on whether the MR probes and the MR assembly/apparatus operate with the same or with different nuclear species, the corresponding resonance frequencies (Larmor frequencies) will be the same or different.

As also generally known, each Hall probe typically comprises an electrically conductive element, henceforth denoted as "Hall element", preferentially exhibiting a high charge carrier mobility, mounted in an appropriate holder provided with mechanical and electrical connection means. The Hall element comprises at least two electrical contacts for driving a bias current and at least two contacts for detecting the transverse voltage (Hall voltage) induced by the Hall effect. Said contacts are preferentially arranged pairwise orthogonally to optimally allow tapping the voltage transversely to the bias current direction. Particular embodiments exhibit a symmetrical and interchangeable (between biasing and voltage tapping) arrangement of the conductive element and its contacts allowing to switch or rotate the bias current direction. The induced Hall voltage is thereby indicative of the magnetic field or flux density perpendicular to said bias current direction and direction of the measured transverse voltage. The vector along which the magnetic field/flux is sensed (i.e., the component of the field that is sensed) by the Hall element is called "Hall axis" in the further. Embodiments of Hall probes typically employ a planar Hall element confining the direction of bias current flow and voltage tapping by its geometry. The Hall axis is then typically along the normal of said planar Hall element. However, also vertical, bulk and cylindrical Hall elements exist and are applied and operated analogously to planar elements. In particular, multiple Hall axes can be implemented in a single conductive element by corresponding arrangement of contacts for biasing and Hall voltage detection.

Although the Hall effect refers to a pure transverse voltage, the signal provided by a Hall probe can be internally buffered, amplified, temperature corrected or even digitized. Hence, the actual output of the Hall sensor will henceforth be called "signal", with the understanding that such signal is indicative of the magnetic field flux along the Hall axis. This shall also encompass the case mentioned above, that several signals are obtained from a single conductive element or integrated plurality of conductive elements (e.g., 2D or 3D Hall sensors).

According to one embodiment, the Hall element is quasi-two-dimensional (claim 2). The term shall be understood in connection with that region of the Hall element responsible for generating the Hall effect. So, the term shall not only apply to Hall elements made of a material having a quasi-two-dimensional shape such as, in particular a graphene sheet. The term also applies to Hall elements having a finite thickness but including some kind of quasi-two-dimensional layer acting as the region giving rise to the Hall effect. Examples for such devices are based on (high mobility) semiconductor heterostructures, doping modulation or quantum wells. Alternatively, thin layer technology can be applied to confine the charge carriers in a quasi-2D layer. Besides the mentioned graphene layers, metal dichalcogenide and heterostructures base on oxides (e.g., ZnO/ZnMgO) were reported to successfully form 2D conduction layers.

Therefore, according to one advantageous embodiment, the Hall element is a graphene sheet. Using a graphene sheet as the active Hall detection conductor, the sensitivity is increased compared to devices with other types of sheet. Because a graphene sheet has a thickness of only one atomic layer, its magnetic field detection effect is fully axial. Moreover, graphene-based sensors show good performance at cryogenic temperatures, which allows operation in the environment of superconducting elements inside cryostats. Based on these abilities, Hall probes of this type can be employed for a range of applications in the realm of field sensing inside of MRI and NMR spectrometers. This is particularly useful in conjunction with MR based field probes, which ideally complement the Hall probe's abilities.

Other types of quasi-two-dimensional Hall elements, some of which are commercially available, can be built up from layers of suitable materials such as gallium arsenide (GaAs), aluminum gallium arsenide (AlGaAs), indium arsenide (InAs), indium phosphide (InO), indium antimonide (InSb), gallium nitride (GaN), aluminum gallium nitride (AlGaN) or indium aluminum nitride (InAlN).

In principle, the MR probes could exploit any type of magnetic resonance, including e.g., electron spin resonance (ESR), also called electron paramagnetic resonance (EPR). Advantageously, however, each one of said MR probes is a nuclear magnetic resonance (NMR) probe (claim 3).

There are various embodiments related to the number and location of field probes and to the orientation of the Hall probes. According to the invention, the MR assembly comprises at least three MR probes, which allows determination of the spatial distribution of the magnetic field magnitude in first order, e.g., the distribution in three independent directions defined by a set of (x,y,z)-gradient coils. In a further embodiment, the MR assembly comprises at least four MR probes, which allows determination of the spatial distribution of the magnetic field magnitude up to first order. i.e., including zeroth order contributions. Of course, a larger number of MR probes will allow for a more detailed determination of magnetic field magnitude.

Regarding the orientation of the Hall probes, one should take into account the dominating effect of the main magnetic field. When determining a superimposed magnetic field of interest, a measurement with a Hall probe having its Hall axis along the main magnetic field will require a higher dynamic range than in case of other relative orientations. Therefore, according to an advantageous embodiment, at least one Hall probe has its Hall axis (H) oriented at a non-zero angle with respect to the main field axis (A) (claim 4).

According to a further embodiment (claim 5), the MR assembly comprises at least one group of at least three Hall probes having respective Hall axes oriented to span three non-degenerate spatial directions, thereby jointly providing Hall probe signals indicative of said local magnetic field vector. For such groups of three Hall probes, which will also be addressed as "triplets" of Hall probes, it will be advantageous to minimize the mutual distances between the individual Hall probes. For certain applications, it is advantageous (claim 6) if each one of said Hall probes has its Hall axis (H) oriented at a non-zero angle with respect to the main field axis (A).

Various further embodiments seek to reduce various problems related to the operation of the Hall probes.

In order to minimize the problems caused by temperature drifts, it is advantageous if at least one of the Hall probes is provided with temperature detection means and optionally with temperature regulation means. According to another embodiment (claim 7), at least one of the Hall probes is configured as gradiometer probe comprising a pair of parallel Hall elements. According to a further embodiment (claim 8), each Hall probe is connected to an AC lock-in detection circuitry and/or to a current spinning circuitry.

Transmission of analog measurement signals within an MR assembly can be implemented in an advantageous manner by using current signals driven by current sources. Therefore, according to one embodiment (claim 9), each Hall probe is equipped with an electronic device for converting the Hall probe signal to a corresponding current mode signal.

Further advantageous embodiments of the invention exploit the complementary properties of Hall probes and MR probes. In one embodiment (claim 11), offset and gain of each Hall probe signal are adjusted according to a momentary estimate of the local magnetic field magnitude obtained from the MR probes. In another embodiment (claim 12), each Hall probe is operated continuously at least during an image or contrast encoding portion of an MR acquisition sequence or during an MR service sequence. According to a further embodiment (claim 13), the MR probes are operated only in selected time periods of an MR acquisition sequence or MR service sequence. In yet another embodiment (claim 14), a temporal field integral during a dead time of an MR probe is determined from at least one of the Hall probe signals.

Due to the fact that the Hall probe signals are generally available without interruption, an advantageous embodiment (claim 15) relies on a continuously acquired Hall probe signal, which is used to generate a trigger event based on the temporal field evolution.

Such trigger event can be generated by matching, comparing or correlating the measured field evolution, orientation or amplitude with expected field evolutions of a portion of a sequence in order to detected particular instances in time within the MR sequence. The generated trigger can then start for instance an MR field probe measurement, time actions of other peripherals such as stimuli applied to the subject or align the acquired data. Furthermore, trigger events based on measured deviations of the expected field evolution during execution of an MR sequence can be employed to flag acquisitions or parts of acquisition that might be affected by externally induced fields, field drifts of the MR system or subjection motion. These flags can then be employed to mark images as potentially corrupted, instigate re-acquisition of the corresponding data or inform means for prospective and/or retrospective motion correction.

A trigger event can in particular be generated based on matching the measured gradient waveform to a predetermined pattern, orientation or strength in order to identify a particular time in the execution of the MR sequence. Furthermore, trigger events can be generated upon detecting unexpected field changes caused by incorrect execution of the sequence, externally induced fields or field induced by subject motion. The controller can in this case trigger the acquisition via the MR probes or flag the acquired portion of data for correction or re-acquisition.

The Hall probes can be employed to obtain information on so-called "concomitant fields", i.e., field components induced perpendicularly to the main field axis of the MR assembly induced by the gradient and shim system, in order to improve the field estimation resulting from the MR probe data. Therefore, according to an advantageous embodiment (claim 18) of the method of operating an MRI apparatus, the reconstructing of images uses information on magnetic field magnitude obtained from the MR probes in combination with information on magnetic field vector component obtained by at least one Hall probe for estimation of concomitant field contributions to image and contrast encoding and/or for estimation of related correction parameters.

Brief description of the drawings

The above mentioned and other features and objects of this invention and the manner of achieving them will become more apparent and this invention itself will be better understood by reference to the following description of embodiments of this invention taken in conjunction with the accompanying drawings, wherein are shown:

Fig. 1    a) a schematic representation of an MR assembly, in a perspective view, and b) a schematic representation of an MR probe, in an enlarged perspective view;

Fig. 2    a schematic representation of a Hall probe, in a perspective view;

Fig. 3    implementations for operating Hall probes inside an MRI magnet, wherein a) depicts a Hall sensor with a Hall inside the imaging volume of an MRI scanner and means for operating said element outside the imaging volume, whereas b) shows a setup with analog components for biasing and reading the Hall element located inside the imaging volume;

Fig. 4    an advanced embodiment of measuring the Hall voltage using a lock-in approach; a) depicts an analog implementation of a lock-in modulation using a single analog-to-digital converter (ADC), and b) shows a corresponding digital embodiment with two ADCs and a digital demodulation stage;

Fig. 5    an embodiment of measuring the Hall voltage using a temporal current spinning scheme, with a) and b) showing two consecutive phases of the process;

Fig. 6    an advanced embodiment of measuring the Hall voltage using a spatial current spinning scheme;

Fig. 7    a pair of Hall probes arranged as gradiometer, with a connection in series (see a) top) or in anti-series (see b) bottom);

Fig. 8    a triplet of Hall probes arranged as a vector magnetometer, in a schematic perspective view;

Fig. 9    a) an arrangement for measurement of gradient coil induced fields separated in mostly MR active direction along the main magnetic field (solid arrow $B_0$) and the concomitant field terms (dashed arrow); b) an arrangement of Hall probe oblique to the main field axis; and

Fig. 10    an arrangement with four MR probes and three Hall probes positioned in a volume of interest of an MRI system.

Detailed description of the invention

In general, the same reference signs will be used for functionally identical or similar features in the various drawings and will thus not be described multiple times unless necessary for understanding the invention.

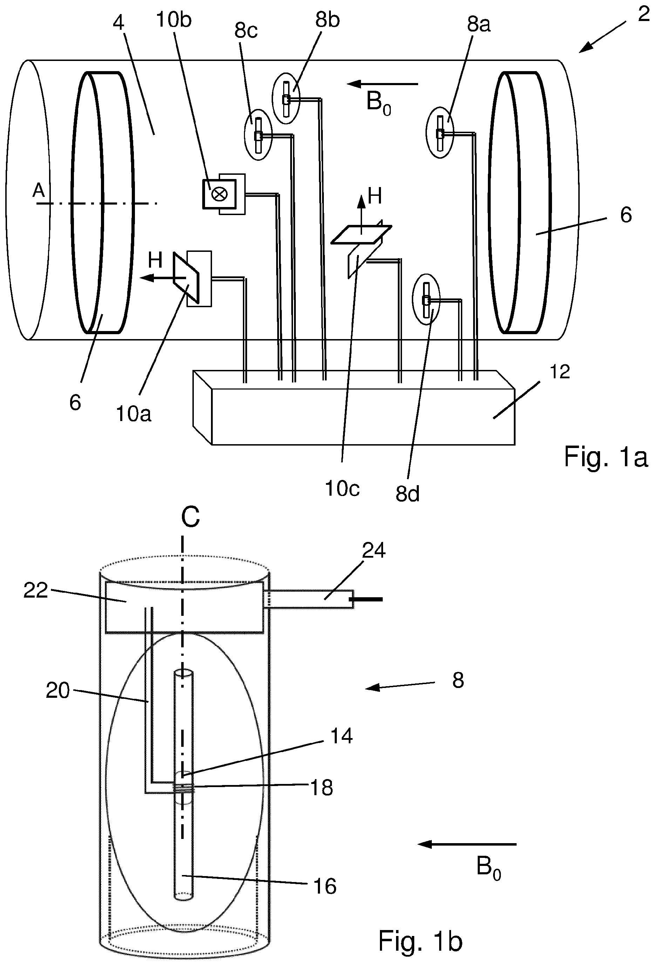

A schematic representation of a MR assembly 2 is shown in Fig. 1a. It comprises a main magnetic field magnet (not shown) providing a main magnetic field $B_0$ along a main field axis A within a volume of interest 4, gradient coils 6 for generating gradient magnetic fields superimposed onto the main magnetic field, with only one gradient coil being shown here. The MR assembly further comprises a plurality of magnetic field probes 8a, 8b, 8c, 8d, 10a, 10b, 10c each positioned within the volume of interest 4, and each magnetic field probe generating a probe signal. A controller 12 is connected to each field probe for receiving and processing respective probe signals. In the example shown, the plurality of magnetic field probes comprises four MR probes 8a, 8b, 8c, 8d and three Hall probes 10a, 10b, 10c.

The principle of an MR probe 8, which in the present example is operated as an NMR probe, is shown in Fig. 1b. The MR probe comprises an NMR active substance 14 contained in a tubular container 16 with a longitudinal axis C, means for pulsed NMR excitation of the active substance and means for receiving from said substance an NMR probe signal indicative of the local magnetic field magnitude $B_0$. In the example shown, these excitation and receiving means comprise a solenoid 18 wound around the tubular container and a pair of connecting leads 20 forming an electrical connection between respective ends of the coil member 18 and an RF coupling unit 22. The latter is configured for connecting to an external RF line 24 which is connectable to external RF driver and receiver means not shown in the figure.

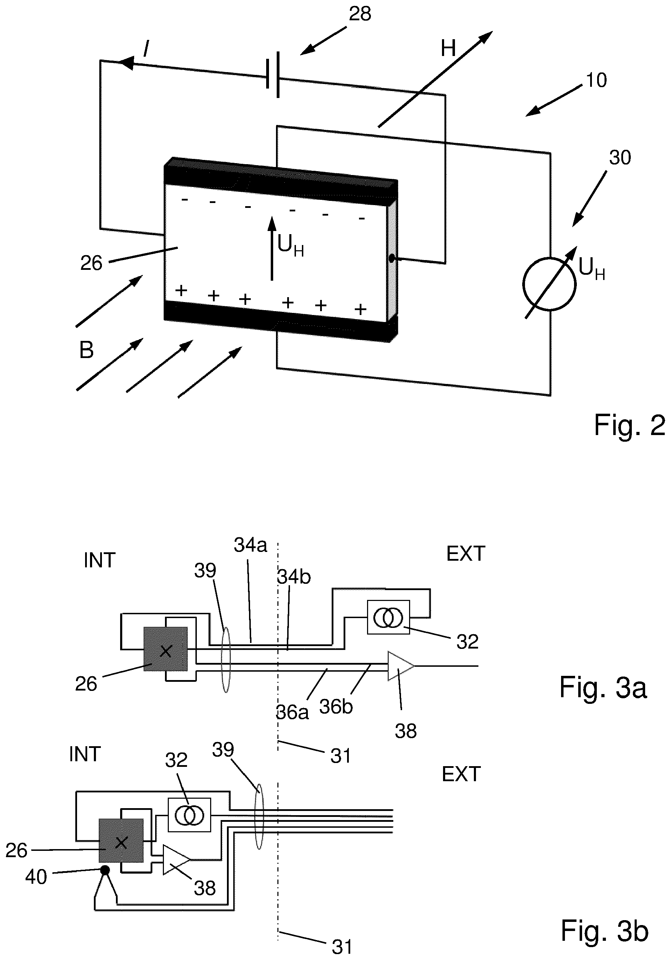

The principle of a Hall probe 10 is shown in Fig. 2. The Hall probe comprises a Hall element 26, which in the present example is configured as a substantially planar sheet, e.g., a graphene sheet, shown here as a plate with appreciable thickness merely for better representation. The Hall probe further comprises means 28 for generating an electric current I within the graphene sheet and means 30 for receiving a Hall probe signal indicative of a local magnetic field vector component perpendicular to the graphene sheet. The Hall probe signal is measured as a voltage $U_H$ in a direction within the plane perpendicular to the electric current direction. Also shown in Fig. 2 is a magnetic field B oriented perpendicular to the plane.

The abilities of the two types of magnetic field probes are complementary in many aspects:

|  | MR | Hall | Graphene Hall |
| --- | --- | --- | --- |
| Sensitivity at high field | Very high | Good | High |
| Acquisition duration | Pulsed with dead times (or echoes) | Continuous | Continuous |
| Linearity/accuracy | Very high | Good | Good |
| Drift | Very low | High | Calibratable |
| Vector detection | No | Yes | Very uniaxial |
| Cost | High | Low | Medium |
| Bandwidth | 2 MHz | 5 MHz | 20 MHz and above |
| Instantaneous Field Dynamic Range / Operating field range | Small (%) by tuned electronics | Very large | Very large |

*Operating Hall probes inside an MRI system*

In the following Figs. 3a and 3b, the regions within the MRI bore and externally thereof are denoted as INT and EXT, respectively. The regions are schematically separated by dashed line 31. It has to be noted that said border 31 might be manifest as an RF shield. In one embodiment this RF shield is a Faraday cage shielding the entire scanner. In one embodiment, the RF shield is surrounding the Hall sensor closely in order to protect the Hall element and the enclosed electronics from RF fields of RF transmission pulses generated by the scanner. It is well known (WO 2014/041147 A1) that such RF shields can be manufactured so as to effectively shield RF fields yet minimally influencing magnetic fields at acoustic frequencies. This allows RF shielding of field sensors without hampering the field measurement of gradient switching fields. In a simple implementation as shown in Fig. 3a, the biasing measurement current I is a DC current being routed from DC current source 32 to the Hall probe via two current leads 34a, 34b.

The Hall voltage $U_H$ is detected using a high impedance voltmeter (not shown) being connected via two voltage leads 36a, 36b. It is common understanding, that biasing leads and the voltage detection lead pairs are preferably twisted in order to minimized induction of voltages by switched external magnetic fields. Furthermore, the voltage is preferably measured differentially by means of an instrument amplifier 38. The DC bias current source 32 is preferably of high impedance and temperature stabilized as well as routed differentially.

In other implementations as shown in Fig. 3b, the Hall voltage is measured ratiometrically to the bias current. The ratiometric detection can be implemented in analog domain (e.g., via using a voltage proportional to the bias current as reference for the ADC or controlling the gain of an amplification stage in proportion to the bias current) or in digital domain (e.g., simultaneously sampling the bias current and the Hall voltage). Also shown in Figs. 3a and 3b is an RF trap 39 serving as protection against coupling-in of high-power RF fields emitted by the MRI system.

A high impedance, differential detection with high common-mode signal rejection can be achieved by use of instrumentation amplifier for amplifying the Hall voltage. The instrumentation amplifier can be implemented by a linear amplifier configuration or using switched capacitor topologies.

Temperature drift can be compensated by detecting the temperature of the Hall element. For this purpose, a thermistor 40, an optical temperature sensor or the resistance of the Hall element itself can be employed. Calibration values can then be updated with respect to said device temperature. The required calibration values can be determined with respect to temperature from a previously determined model, calibration curve or look-up-table.

The stability of the Hall probe can be further improved by keeping the temperature of the Hall element steady by oven-control. The temperature can thereby be controlled by feedbacking the temperature measured by mentioned thermometers (e.g., a thermistor, 40) to a heating/cooling unit at the probe. Such a heating source can be an electric resistor attached to the Hall element in a similar fashion as said thermistor. In a one embodiment, the thermistor itself can be employed as temperature and heating element by varying its bias current to regulate the temperature to a steady value as read from said thermistor's resistance. The heat can be produced by ohmic losses in a resistor thermally coupled to the Hall probe, a Peltier element (which would also allow for cooling) or an optical absorber connected to an optical fiber. The latter would allow galvanically isolated heating by a remote source light/IR source.

As mentioned, induction by external switching fields is found to pose considerable problems in operating Hall probes in MRI fields. This because typical MRI systems have field switching in the order of several 100 T/s which makes detection of $\mu$V scale Hall voltages very error prone. To avoid this problem, the detection electronics can be adapted:

The detection electronics can be implemented very close to the detector and offering minimal induction areas. Amplification of the Hall voltage near the Hall element as shown in Fig. 3b will reduce the susceptibility to induced external switching fields.

Transmission of analog measurement signals in the bore of the MRI signals can be implemented as current mode signals driven by current sources with high impedance outputs. Given a high output impedance of such active current sources, the current detected at the receive end will still be in proportion to the emitted signal due to Kirchhoff's conservation law of current. This can be achieved by using transconductance amplifiers at the output of the Hall probe as well as high impedance current sources for generating the bias current.

A preferred embodiment of the detection electronics/method employs a modulated bias current to the Hall probe. This allows shifting the detection frequency band of the Hall voltage to a part in the spectrum with low electromagnetic interference. In a preferable embodiment in MRI systems, the frequency band of field measurement is shifted above the cut-off frequency of the gradient system, the latter typically being several tens to hundreds of kHz. Also DC offsets can be averaged out by using an AC detection scheme. The large bandwidth of graphene-based Hall probes is ideally suited for such approaches.

Measurement contamination induced by planar Hall effects can be similarly suppressed by current spinning of the bias current. By spinning the exciting current around the Hall axis and correspondingly orienting the orientation of the Hall-voltage axis ideally averages out the planar Hall voltage component. It is understood, that current spinning and lock-in detection can be beneficially combined.

Bias and measurement leads for the Hall probe as well as the Hall probe and its electronics have to be appropriately protected against coupling of high-power RF fields emitted by the MRI system. This is necessary for operating the Hall probe under RF irradiation but also for ensuring that the MRI system can be operated safely and unaffected by the presence of the Hall probes and their leads. For this purpose, standard means known from MRI coil and MRI field probe engineering such as RF chokes, filters, baluns, floating baluns and bypass capacitors as well as gradient compatible RF shields can be employed. However, since the required leads are either used to carry a constant current or to connect to ports of high impedance nature, the resistance of the wiring or the resistivity of the employed conductor can be high. Hence high resistivity wires can be employed as leads for the Hall probes minimally influencing the RF fields of the MRI system. This in particular, if the instrumentation amplifier is located in close vicinity of the Hall element.

Transconductance amplifiers can be applied at the driving ports (outputs) of the signal lines in order to provide a high output impedance for the transmitted signal. As a result of such a configuration, the signal is transmitted in current-mode providing a high immunity to externally induced voltages by the dynamic regulation of the signal current provided by the transconductance amplifier.

The leads to the Hall probe may be of comparably high resistance particularly reducing adverse coupling to the RF fields produced and received by the MR assembly. High impedance wires could consist of typical resistance wire material but also of advanced composite conductive materials such as graphite or carbon fiber containing polymers, silver colloids or micro/nano wire containing polymers, electrically conductive plastics, rubbers or silicones etc. Necessary power sources for these electronics can be provided locally by use of batteries, large or super-capacitors, opto-electric transducers, via wireless power transfer or harvesting from the MRI scanner operation via using the induction of switch gradients or RF pulses.

Of course, transduction to optical signals and optical powering enables galvanic isolation. This can be achieved converting the reading of the probe in close vicinity of the Hall element and routing the probe information digitally via optical fibers or wirelessly out of the bore.

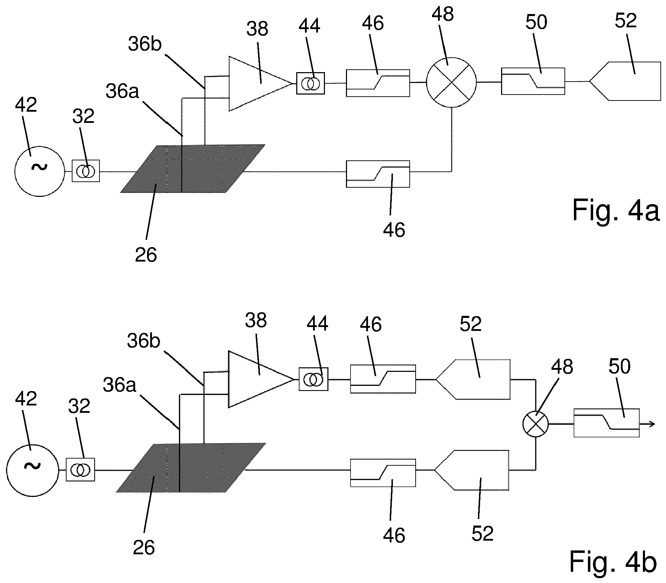

Advanced implementations of measuring the Hall voltage using a lock-in approach are shown in Fig. 4. In order to provide higher resistance against externally induced voltages into the leads, controlled current sources and filter stages can be deployed. In particular high-pass filters can be used to block induced voltages below the modulation frequency. The demodulation and bias current correction step can be applied in analog domain (Fig. 4a) or digital domain (Fig. 4b). In these figures, there are shown, from left to right, an AC signal source 42 driving a modulating current source 32, a Hall element 26, and voltage leads 36a, 36b being fed into an instrument amplifier 38. The output from the latter is used to drive a further current source 44 which generates a current signal indicative of the relevant Hall signal. High pass filters 46, a mixer 48, low pass filters 50 and analog-to-digital (ADC) converters 52 are arranged to carry out demodulation and bias current correction in the analog or digital domain.

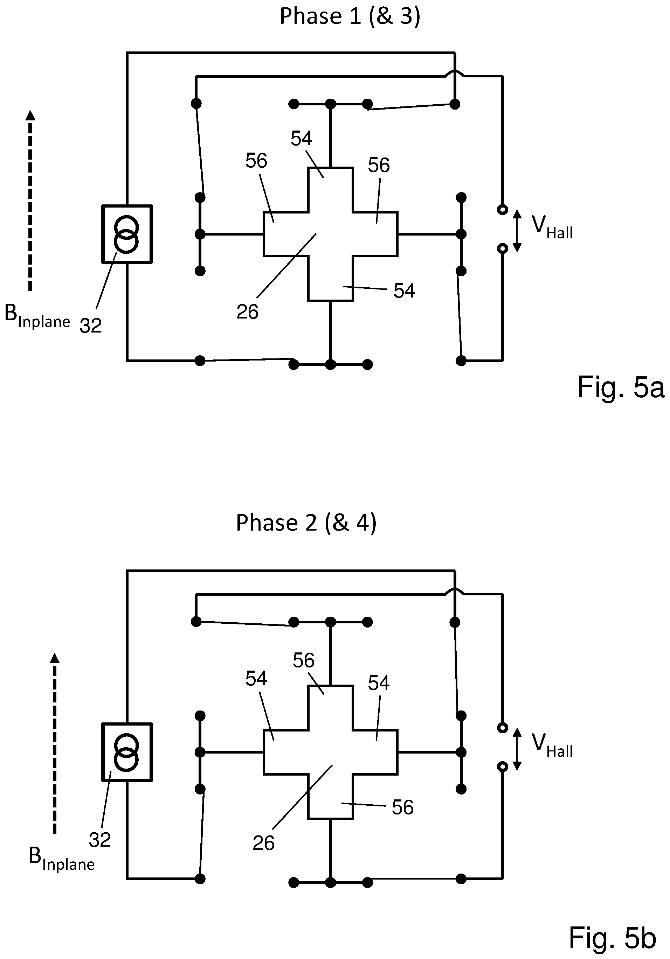

Temporal current spinning, as illustrated in Figs. 5a and 5b, uses the arms of a Hall element 26 alternatingly as bias terminal 54 and as measurement terminal 56. The bias current can be alternated in direction for each opposing terminal pair.

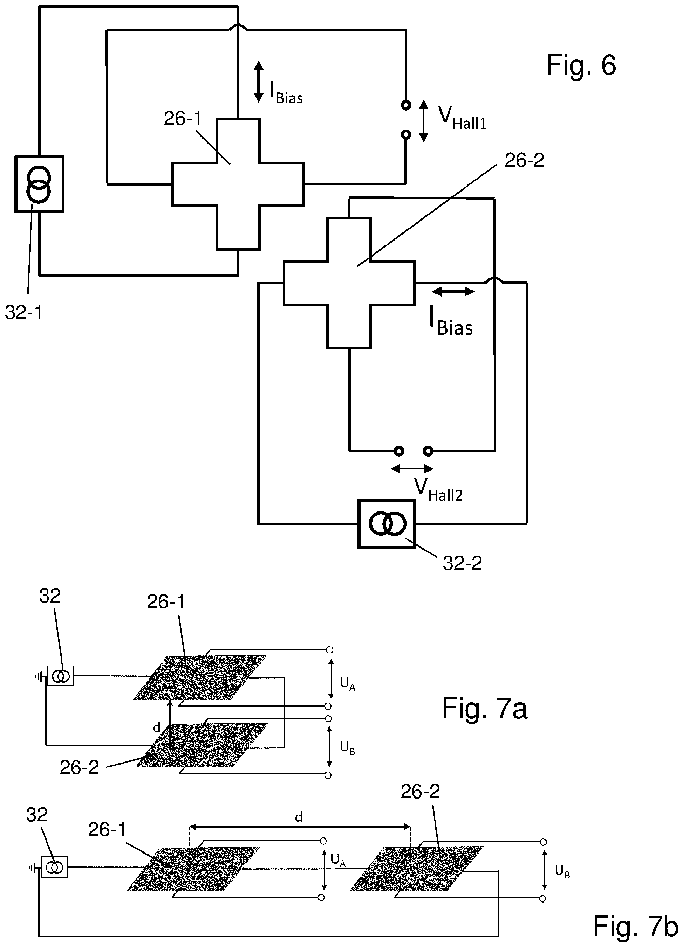

Spatial current spinning, schematically illustrated in Fig. 6, is established by using at least two identical Hall probes with respective Hall elements 26-1 and 26-2 in close vicinity and preferentially with mechanical and thermal coupling. The two Hall elements are driven by respective current sources 32-1 and 32-2. The difference in bias current direction helps to suppress the in-plane Hall effect in the sum (or correspondingly to its relative orientation difference reading) of the magnetic field reading of the two Hall plates probes.

As shown in Fig. 7, two Hall probes with respective Hall elements 26-1 and 26-2 can be arranged as gradiometer sharing the same bias current. Fig. 7a depicts the case sensing the gradient of the magnetic field component pointing in the direction of the Hall axis of the respective Hall elements. Furthermore, the gradient is obtained by adding both Hall voltages due to the antiparallel orientation of the bias current. Fig. 7b shows an arrangement in which the gradient derivative is oriented orthogonally to the component of the magnetic field that is sensed. The gradient is obtained by forming the difference of the two Hall voltages due to the parallel orientation of bias current. Depending on the direction of current flow, the Hall voltages have to be added or subtracted to obtain the magnetic field gradient in terms of the ratio of the field difference and the distance d between the Hall elements. The difference in Hall voltage can be obtained in analog by well known instrumentation /operational amplifier adder/subtractor circuits or in digital domain by sampling both Hall elements separately. The first approach has the advantage, that the dynamic range and drift requirements are reduced due to the suppression of the Hall voltage induced by the uniform field.

*Calibration of Hall probes using MR field probes*

Combining Hall and MR field probes allows to (re-)calibrate the Hall probes using the measurements of the MR field probes. For this, the field magnitude retrieved by the MR field probes is inter- or extrapolated to the position of Hall probe using well known methods described in [Barmet2008]. The field magnitude value at the position of the Hall probe can then be considered as calibration reference values for the Hall probes. The offset and gain of the Hall probe calibration must then be adjusted such that the output of field magnitude of the Hall probe matches that of the MR field probes. The field induced by the main magnet can thereby be used as reference for calibration for reading of field strength and orientation. Furthermore, the number of reference field strengths and orientations usable for calibration of the Hall array can be increased by employing the gradient and active shim system of the MRI system. As detailed in the section on Hall sensor calibration below, acquiring reference values by the Hall probes under different combination of known or at least measured - by the MR field probes - gradient and shim field strengths allows calibrating parameters such as position and orientation as well as gain and offset in orientations off-axis to the main field of the individual Hall sensors.

It is understood that referencing the field magnitude value of Hall probes can be employed to recalibrate for offset values and drift, field response non-linearities, temperature drift and alike. It is preferred to use 3-axis Hall probes because then the field magnitude can be readily calculated. However, if the angulation of the field and the Hall probe is known, the analogous procedure can be applied for the field component along the Hall axis.

The angular orientation of the Hall axis of a Hall probe assembly can be calibrated in an external well defined magnetic field as found in an MRI magnet. The fixed arrangement of Hall probes is thereby exhibited to a set of known rotations. It is then assumed that each measurement axis has a tilt to the assumed ideal axis and a gain error. Standard approaches using known and partially known calibration field properties can be applied to calibrate the field probe and the array [Hemanth KS, Proc. IFAC 2012(45;1), 175-178, DOI 20120213-3-IN-4034.00033].

It is known that several Hall plates can be arranged to form a vector sensor, i.e., three Hall plates arranged orthogonally to each other in order to sense each a component of the magnetic vector field. Such a triplet of orthogonal sensors can be aligned with the main magnetic field, i.e., the normal vector of one Hall plate is aligned with the main magnetic field. For estimating the MR active field however, the magnitude must be calculated from the three readings.

Since this reading is independent of the orientation of the sensor triplet, the vector sensor can also be arranged in oblique orientation to the main field. This distributes the high dynamic range direction to all three sensors dividing the dynamic range requirements of the electronics by a factor of $\frac{1}{\sqrt{3}}$. Furthermore, all Hall sub-devices are then operated in a similar regime by exposing every one to a similar field strength and field angulation. Consequently, non-linearity and planar Hall effects are similar for all measured components.

A triplet of Hall probes is however subject to different inaccuracies. As explained above, some can be suppressed by beneficial operating conditions, e.g., offset errors can be suppressed by modulation and chopping approaches, planar effects by current spinning etc. However, gain errors and misalignment of the Hall plates relative to each other have to be considered separately.

Generally, the effect on the magnetic field measurement of the latter inaccuracies can be expressed by:

$$B = HB_{Hall}$$

The Hall tensor *H* thereby translates the three readings from the Hall probes to the real B field vector correcting of sensor misalignment and individual gain errors.

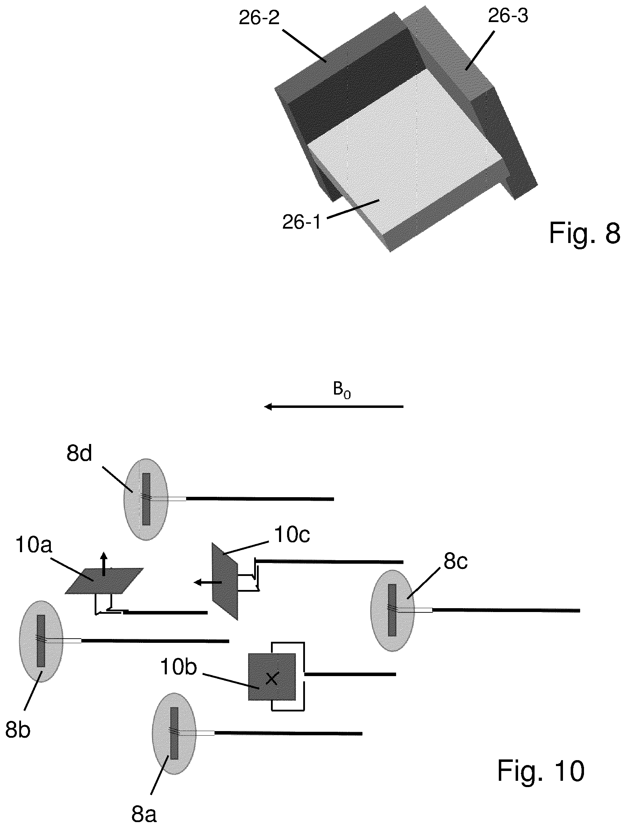

A triplet of Hall probes with respective Hall elements 26-1, 26-2, 26-3 arranged to form a vector magnetometer is shown in Fig. 8. The triplet of probes can be calibrated by rotating it in the main magnetic field under monitoring of MR field probes e.g. the Hall element triplet can be oriented along each main axis (x,y,z) and oblique axis ($\pm 1$, $\pm 1$, $\pm 1$) of the basis coordinate system. The calibration values have then to be such, that the field magnitude reading from the Hall probes and the MR probes is consistent:

$$|B| = B_{Hall}^T H^T H \, B_{Hall} = B_{Hall}^T \, C \, B_{Hall}$$

However, as a consequence of considering only the magnitude reading, only the six degrees of freedom of the positive symmetric tensor *C* are finally required. These six values can be obtained by fitting the readings ($B_{Hall,i}$) from two or more measured orientations (*i*) to the field magnitude measured by the MR field probes at the position of the Hall probe triplet ($b_i$).

$$C = \begin{pmatrix} c_{11} & c_{12} & c_{13} \\ c_{12} & c_{22} & c_{23} \\ c_{13} & c_{23} & c_{33} \end{pmatrix}$$

$$b_i = B_{Hall,i}^T \, C \, B_{Hall,i} \text{->} C = argmin(\sum_i \left\| b_i - B_{Hall,i}^T \, C \, B_{Hall,i} \right\|^2)$$

The Hall tensor *H* cannot be uniquely and generally derived from the calibration tensor *C*. However, under certain assumptions estimates can be made.

If it is assumed that the misalignment is small, only terms up to linear order of the off-diagonals of H need to be considered:

$$C = \begin{pmatrix} H_{11}^2 + H_{21}^2 + H_{31}^2 & H_{11} \cdot H_{12} + H_{22} \cdot H_{21} + H_{31} \cdot H_{32} & H_{11} \cdot H_{13} + H_{33} \cdot H_{31} + H_{21} \cdot H_{12} \\ ... & ... & ... \\ ... & ... & ... \end{pmatrix}$$

$$\approx \begin{pmatrix} H_{11}^2 & H_{11} \cdot H_{12} + H_{22} \cdot H_{21} & H_{11} \cdot H_{13} + H_{33} \cdot H_{31} \\ ... & ... & ... \\ ... & ... & ... \end{pmatrix} + O(H_{ij,i \neq j}^2)$$

It is seen, that in this case the gain correction in the main axis can directly be read from the square root of the diagonal elements of C. The six tilt factors $H_{ij}$ can then be derived by solving the coupled linear system of equations from the six off-diagonals above using the known diagonal terms $H_{ii}$.

$$C_{12} = H_{11} \cdot H_{12} + H_{22} \cdot H_{21}$$

$$C_{13} = H_{11} \cdot H_{13} + H_{33} \cdot H_{31}$$

$$...$$

It must be noted, however, that for determining the effect of the magnetic field on MR processes in general only the field magnitude is needed. For interpolation of the magnetic fields on the other hand, considering its vector nature is beneficial for which mentioned calibration of the three axis Hall system is of importance.

Once the Hall triplet is calibrated as outlined above, the orientation of the triplet in the magnet can be determined by the direction of main field axis in order to discriminate collinear and concomitant fields. This by applying the H tensor to obtain the true direction of the main magnetic field relative to the Hall triplet.

One of the main drivers for drifts and offset is related to the temperature of the Hall device. Considering a mentioned integrated multiplet of Hall probes, a joint drift of gain ($\Delta g$) on all axes without altering their relative angulation can be assumed

$$B = (1 + \Delta g) H B_{Hall}$$

The gain drift factor can be estimated using the information provided by the highly stable MR field probe(s) co-residing in the same magnet. Using well known methods to spatially interpolate or extrapolate the field magnitude value measured by MR to the position of the Hall probe or Hall probe array ($|B_{MR}|$). This results in the following relation:

$$|B_{MR}| = |(1 + \Delta g) H B_{Hall}|$$

and hence

$$\Delta g = \frac{|B_{MR}|}{|H B_{Hall}|} - 1$$

This calibration method can also be employed with slight modification if not all three directions of the magnetic field are measured by the Hall probes. In this case, the angulation relative to the measured field has to be known or estimated and the measurements for calibration or drift correction have to take place when the direction of the magnetic field employed is substantially equal for each calibration. In this case, the reading of each Hall probe will be reduced by the angulation $\theta$ relative to the field direction. Assuming a constant or known angulation results in the following calibration relation or each Hall probe:

$$\Delta g = \frac{\cos(\theta)|B_{MR}|}{|H B_{Hall}|} - 1$$

In case the angulation is not known, the readings of the Hall probe can be held constant by the method described above assuming a constant effective angulation.

The position of the Hall triplet in the MR assembly can be calibrated by switching on and off the gradients of the MRI system. Analogously to the MR field probes, their position in the MRI system's gradient coordinates can then be derived from the field offset gradient induced by each gradient axis.

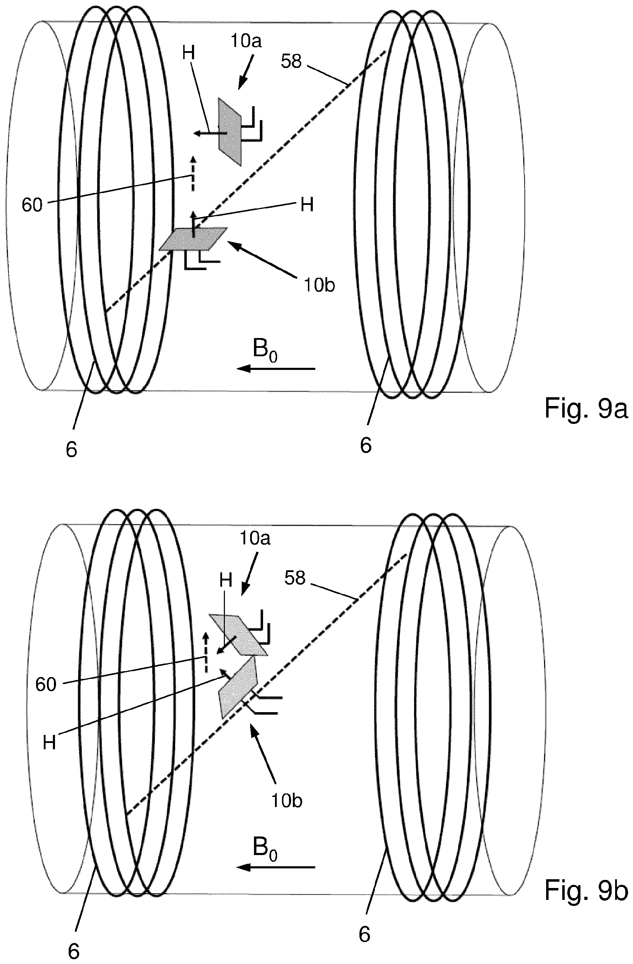

Fig. 9a shows a measurement of gradient coil induced fields (the dashed line 58 indicating the slope of the field aligned with the $B_0$ field direction) separated in the mostly MR active direction along the main magnetic field $B_0$ and the concomitant field terms 60 (dashed arrows). Each Hall probe 10a, 10b gives directly the information on the corresponding field component in accordance with its directional sensitivity along its Hall axis H. Sampling different field components with different orientations allows to account for the orientation dependent effect of the induced magnetic field on the MR. Fig. 9b shows an arrangement of Hall probe oblique to the main field axis. Although the field output of each Hall probe cannot be directly interpreted in terms of its action on the MR sequence but have to be interpreted via a spatiotemporal field model, the dynamic range needed for reading each Hall probe is significantly reduced in comparison with the arrangement of Fig. 9a.

*Using a combination of MR and Hall field probes for dynamic field monitoring and sequence recording in an MRI system*

MR based field probes have been proven to provide valuable information on the sequence as being performed in the MRI scanner. The combined operation of the MR and Hall field probes can expand the ability of such a system:

Detecting the magnetic vector field or additional vector components thereof in the scanner e.g., to derive the effect of concomitant fields on the spin dynamics in the subject during encoding of the image [Norris1990] or contrast generation e.g. [Bernstein1998, Baron2012] (see above). Currently applied approaches for correction of concomitant field effects on MR field probe data [Wilm2020] suppose a generic model of the radially induced fields. However, a vector field measurement allows using an actually measured field evolution. The measurement inherently includes effects induced by non-ideal gradient coil winding pattern, asymmetric gradients and eddy current induced fields, which are typically hard to depict in generic models. Operating the Hall probes continuously provides information on the sequence even if the MR field probes cannot acquire. Thereby a full coverage of the sequence can be obtained.

As shown in Fig. 10, using MR based field probes 8a, 8b, 8c, 8d and Hall probes 10a, 10b, 10c jointly in an MRI system allows to cross calibrate the two probe systems.

The measurement value of the Hall probes can be corrected for drift and offsets using the information gained in time intervals where both subsystems acquire the field evolution. In particular, the gain and offset of Hall probes can be calibrated by the MR field probes in-situ by extra- or interpolating the field information spatially to the position of the Hall probe. The calibration parameters can then be derived by numerically enforcing a consistent field measurement of both subsystems. In a preferable embodiment, the Hall calibration parameters are adjusted to enforce a consistent field magnitude reading. This calibration process can also take known information or models on the field distribution of gradient and shim coils into account. Most easily, this calibration is however performed in time intervals where the gradient and shim system are off or at least in steady operation.

Complete temporal coverage of the field sensing can be achieved by such a system by completing the field evolution as measured by the MR probes with the information obtained from the readings of the Hall probes during periods when the MR field probes cannot acquire. This can be achieved by fitting the measurements of both subsystems to the same common spatial basis set. The input given by each probe to this fit is preferably weighted by the estimated accuracy or precision of each probe in each moment in time in order to obtain the minimum error fit results for the field evolution in the scanner. If MR probes for instance cannot acquire field values, their weighting to the fit shall be set to 0.

The Hall probe readings are not deteriorated by strong gradients or large induced gradient moments and can therefore measure also strong gradient lobes as for instance employed for diffusion, velocity or displacement encoding or spoiling. This information can be used to correct diffusion/velocity/displacement values obtained by such encoding in post-processing or by correction of the induced gradient moments in the sequence. Furthermore, quantification or image artefacts based on deviating spoiling or refocusing gradients can be corrected or compensated. However, also effects of concomitant fields can be measured by the vector capability of the Hall probes and error induced by said concomitant encoding field terms can be corrected in the finally reconstructed data sets [Baron2012].

When combining the measurements from the Hall probes and the MR field probes, their complementary nature has to be taken into account. This is achieved by:

- Using the MR field probe information for calibrating/compensating drift and offsets of the Hall probe readings
- Completing the MR probe information with the vector field information of the Hall probes (see concomitant fields).
- Filling the gaps in the acquisition of the MR field probes by information from the Hall probes.
- Employing the field evolution known from measurements of the Hall probes to track the phase evolution inside the MR probes and restoring the correct phase evolution even over intervals in which the MR signal of the MR probe is dephased. This allows resolving an ambiguity arising in cases where the signal of the MR probe is dephased and rephased shortly afterwards and thus the k-space trajectory cannot be recovered straightforwardly based on the MR probes' field information alone because the phase of the MR field probe signals has a $2\pi$ ambiguity.

- Increasing the spatial resolution (spatial order) of the MR probe-based array by the Hall probe information. This because the Hall probes can be placed in additional measurement points which might be unfavorable for MR probes due to the presence of strong local static field gradients. The replacement can also be more cost effective. Field evolution of low temporal frequency where gain drifts and offsets would be particularly detrimental for the estimated k-space trajectory, can be disregarded. This because most dynamic field behavior of higher order is induced by local eddy currents, which are typically very low at low frequencies. Thereby, the additional Hall probes can help to suppress folding in of higher order field evolutions into the estimate of the k-space trajectory based on the MR field probe data.

- Extending the range in k-space the combined array can deliver in comparison to an array consisting of MR arrays solely. Once the MR probes are dephased by the read-out gradient pulses, the information of the Hall probes can be used to track the outer portion of k-space trajectory.

- Using the Hall probe information in an GIRF/GTF- measurement [Vannejso2013] or harvesting [Wilm2019] approach, also in conjunction with an MR field probe array. Also here, the Hall probe array delivers a high temporal, uninterrupted coverage while the MR probe array would deliver measurements with high accuracy and low drift. The information of the different probe arrays is then fused, preferably applying appropriate weighting considering precision and accuracy of the measurement in space and frequency. Based on the information gained by the Hall probes, information on the field evolution perpendicular to the main field direction can be included in the obtained GIRF/GTF model of the system and the potentially derived parameters for system installation and calibration derived therefrom.

- Using the Hall probes in a field camera for monitoring the ramping of a magnet or determining the location of the camera in the magnet bore in relation to the measured field. This exploits the fact that the dynamic range in magnetic field of the Hall probe reaches from 0 to very high fields (main field).

*Measurement of concomitant fields*

The (stationary) vector field of gradient coils can be measured in the main magnet - irrespectively of being (partially) on field or not - by scanning the Hall probe in the volume of interest and in the angulations of interest. The background field of the main magnet and potential other sources can be subtracted from measurements made at the same positions where the gradient field was turned off or ramped to a known, different strength. However, the direction of the main magnetic field can furthermore be used to orient the vector field measurements taken by the Hall probes in relation to the polarization of the main magnet. The direction of the main field can be determined using such a Hall probe. The found direction at each location can be used to determine the components aligned with and oriented perpendicularly to the main field of the fields mentioned above locally. The orientation of the gradient (shim) coil induced field components are determined for their effect on the MR.

Dynamically induced concomitant fields, i.e., magnetic fields perpendicular to the main field direction, can be measured during switching, pulsing, oscillating or chirping of the gradient field. Their dynamic properties can be studied in analogy to the field component in z-direction by characterization of their response function [Vannejso2013] with respect to the driving terms applied to the gradient or shim axis.

The position of a Hall probe in the MRI system can be calibrated using the same sequence of gradient pulses as used for determining the position of MR field probes, preferably after calibrating the gain of the Hall probe. Alternatively, the position of the Hall probes relative to the MR field probes can be predetermined by the mechanical construction, a mechanical, optical or x-ray measurement or a previously performed reference measurement as described above. The relative positions between MR and Hall array can then be used to determine the position of one subsystem once the position in the scanner of the respective other has been determined.

It is regarded as key advantage of the graphene-based Hall probe to be highly unidirectional. This is very important for the measurement of concomitant fields, because contamination of the main magnet's field must be fully suppressed. This because the field in an MR or MRI system is highly uniaxially polarized with the main field being typically several 100 times larger than the concomitant fields to be measured. Slight off-axis sensitivity (e.g., planar Hall effect) of the Hall probe would contaminate the measurement.

In order to truly relate the uniaxial response of the Hall probe to the geometric alignment of its packaging/surrounding, susceptibility matching technology as employed for the MR field probes might be very beneficial. By an appropriate choice of susceptibility and geometry of the surrounding materials, an aberration of the magnetic field can be avoided or at least characterized.

Finally, conductive structures have to be avoided in the probe because of their potential to carrying eddy currents distorting the dynamic magnetic field reading. It is understood that techniques applied in MRI and NMR systems for eddy current suppression (slotting of conductive structures, thin layers etc.) can be applied analogously.

*Coil integration*

Hall probes can be integrated into RF coils and MRI system analogously to MR field probes. The integration of the Hall probes must consider strongly localized secondary fields as produced by eddy currents running on conductive structures of the coils. Such fields aggravate interpolation of the probe information into the imaging volume and the probes should hence be positioned such that these fields are only minimally picked up.

Furthermore, for MRI compliance, safety reasons and maintaining RF performance of the setup, the RF situation must be considered too. Unwanted RF currents and induced voltages can be suppressed by employing established means such as RF traps, baluns, filters, by passing capacitors, twisted or coaxial signal lines, optical or wireless interfaces as described in a section above.

Furthermore, due to the large dynamic range / operating field, a Hall probe can detect the field in regions with highly non-uniform field as it is typically the case outside the imaging region. Using this data, the coil can be localized along the z-axis of the scanner. This can be used in particular to check for the position of a coil. From the position of a coil one can detect if the coil is mounted correctly, if it should be active or deactivated during scanning given the region of interest. Furthermore, such a system could warn the scanner if a coil is in the magnet but not attached (in particular if autonomously powered via (standby) battery or induction from the MR scanner).

Finally, the employed signals for reading the Hall probe have to be protected against induced voltages from switching gradient or shim fields or by motion or vibration of the Hall probe assembly. As mentioned in a section above minimum inductive signal routing (e.g., twisting), miniaturization, using high-impedance, current mode signaling, lock-in/current spinning methods and alike can be employed for suppressing externally induced voltages in the electronics and signal lines in the reading of Hall probe.

References

| | |
|---|---|
| Norris1990 | Norris DG et al. Concomitant magnetic field gradients and their effects on imaging at low magnetic field strengths, Magn Reson Imag, 8(1), 1990:33-37 |
| Bernstein1998 | Bernstein MA et al. Concomitant gradient terms in phase contrast MR: Analysis and correction, Magn Reson Med 39, 1998:300-308 |
| Baron2012 | Baron CA et al. The effect of concomitant gradient fields on diffusion tensor imaging, Magn Reson Med 68 2012:1190 |
| DeZanche2008 | De Zanche N et al. NMR Probes for Measuring Magnetic Fields and Field Dynamics in MR Systems, Magn Reson Med 60, 2008: 176-186 |
| Barmet2008 | Spatiotemporal magnetic field monitoring for MR, Magn Reson Med 60 2008,: 187-197 |
| Dietrich2016 | Dietrich BE et al. A Field Camera for MR Sequence Monitoring and System Analysis, Magn Reson Med 75, 2016:1831-1840. |
| Sanfilippo2011 | Sanfilippo S. Hall probes: physics and application to magnetometry Proceedings, 2009 CAS-CERN Accelerator School: Specialised course on Magnets |
| Wilm2019 | Gradient Response Harvesting for Continuous System Characterization During MR Sequences, IEEE Transactions on Medical Imaging (Volume: 39, Issue: 3, March 2020) |
| Wilm2020 | Minimizing the echo time in diffusion imaging using spiral readouts and a head gradient system, Magn Reson Imag, 2020 |
| Vannesjo2013 | S. J. Vannesjo et al., "Gradient system characterization by impulse response measurements with a dynamic field camera", Magn. Reson. Med., vol. 69, no. 2, pp. 583-593, Feb. 2013 |

List of reference numerals

| | |
|---|---|
| 2 | MR assembly |
| 4 | volume of interest |
| 6 | gradient coils |
| 8, 8a, 8b, 8c, 8d | MR probes |
| 10, 10a, 10b, 10c | Hall probes |
| 12 | controller |
| 14 | NMR active substance |
| 16 | tubular container for 14 |
| 18 | solenoid |

| 20 | connecting leads |
| 22 | RF coupling unit |
| 24 | external RF line |
| 26, 26-1, 26-2, 26-3 | Hall element |
| 28 | electric current generating means |
| 30 | Hall signal receiving means |
| 31 | RF shield |
| 32 | current source |
| 34a, 34b | current leads |
| 36a, 36b | voltage leads |
| 38 | instrument amplifier |
| 39 | RF trap |
| 40 | thermistor |
| 42 | AC signal source |
| 44 | further current source |
| 46 | high pass filter |
| 48 | mixer |
| 50 | low pass filter |
| 52 | ADC converter |
| 54 | bias terminals |
| 56 | measurement terminals |
| 58 | gradient coil induced field |
| 60 | concomitant field direction |
| H | Hall axis (principal sensitivity direction) |

**Claims**

1. A magnetic resonance (MR) assembly (2) comprising:

   a main magnetic field magnet providing a main magnetic field ($B_0$) along a main field axis (A) within a volume of interest (4),
   gradient coils (6) for generating gradient magnetic fields superimposed onto the main magnetic field according to an MR acquisition sequence or MR service sequence,
   a plurality of magnetic field probes (8, 8a, 8b, 8c, 8d; 10, 10a, 10b, 10c), each positioned within said volume of interest, each magnetic field probe generating a probe signal,
   a controller (12) connected to each field probe for receiving and processing respective probe signals,

   **characterized in that**
   said plurality of magnetic field probes comprises
   a plurality of at least three MR probes (8, 8a, 8b, 8c, 8d), each one of said MR probes comprising an MR active substance (14), means (18, 20, 22) for pulsed MR excitation of said substance and means (18, 20, 22) for receiving from said substance an MR probe signal indicative of a local magnetic field magnitude, and
   at least one Hall probe (10, 10a, 10b, 10c), each one of said Hall probes comprising a Hall element (26) having a respective Hall axis (H), means (28) for generating an electric current within said Hall element and means (30) for receiving a Hall probe signal indicative of a local magnetic field vector component along said Hall axis.

2. The MR assembly according to claim 1, wherein said Hall element is a quasi-two-dimensional Hall element.

3. The MR assembly according to claim 1 or 2, wherein each one of said MR probes is a nuclear magnetic resonance (NMR) probe.

4. The MR assembly according to one of claims 1 to 3, wherein at least one Hall probe has its Hall axis (H) oriented at a non-zero angle with respect to the main field axis (A).

5. The MR assembly according to claim 4, comprising at least one group of at least three Hall probes having respective Hall axes oriented to span three non-degenerate spatial directions, thereby jointly providing Hall probe signals indicative of said local magnetic field vector.

6. The MR assembly according to claim 5, wherein each one of said Hall probes has its Hall axis (H) oriented at a non-zero angle with respect to the main field axis (A).

7. The MR assembly according to one of claims 1 to 6, wherein at least one of said Hall probes is configured as gradiometer probe comprising a pair of parallel Hall elements.

8. The MR assembly according to one of claims 1 to 7, wherein each Hall probe is connected to an AC lock-in detection circuitry and/or to a current spinning circuitry.

9. The MR assembly according to one of claims 1 to 8, wherein each Hall probe is equipped with an electronic device for converting said Hall probe signal to a corresponding current mode signal.

10. A method of operating an MR assembly according to one of claims 1 to 9, wherein a spatiotemporal magnetic field distribution in the volume of interest is determined from values of local magnetic field magnitude obtained from said MR probes and from values of local magnetic field vector components obtained from said at least one Hall probes.

11. The method according to claim 10, wherein an offset and a gain of each Hall probe signal are adjusted according to a momentary estimate of the local magnetic field magnitude obtained from said MR probes.

12. The method according to claim 10 or 11, wherein each Hall probe is operated continuously at least during an image or contrast encoding portion of an MR acquisition sequence or during an MR service sequence.

13. The method according to claim 12, wherein the MR probes are operated only in selected time periods of an MR acquisition sequence or MR service sequence.

14. The method according to one of claims 11 to 13, wherein a temporal field integral during a dead time of an MR probe is determined from at least one of said Hall probe signals.

15. The method according to one of claims 12 to 14, wherein a continuously acquired Hall probe signal is used to generate a trigger event based on the temporal field evolution.

16. A magnetic resonance imaging (MRI) apparatus comprising
an MR assembly according to one of claims 1 to 9,
an RF receiver coil for acquiring object MR signals from an object located within the volume of interest,
wherein the controller is further connected to the RF receiver coil,
and wherein the controller is configured for reconstructing images from a combination of the object MR signals and from the probe signals.

17. A method of operating an MRI apparatus according to claim 16, comprising:

generating gradient magnetic fields superimposed onto the main magnetic field according to an MR acquisition sequence,
acquiring probe signals from said magnetic field probes,
acquiring object MR signals from an object located within the volume of interest,
reconstruction of images from a combination of the object MR signals and from the probe signals.

18. The method according to claim 17, wherein said reconstruction of images uses information on magnetic field magnitude obtained from the MR probes in combination with information on magnetic field vector components obtained by at least one Hall probe for estimation of concomitant field contributions to image and contrast encoding and/or for estimation of related correction parameters.

Fig. 1a

Fig. 1b

Fig. 2

Fig. 3a

Fig. 3b

Fig. 4a

Fig. 4b

# Phase 1 (& 3)

Fig. 5a

# Phase 2 (& 4)

Fig. 5b

Fig. 6

Fig. 7a

Fig. 7b

Fig. 9a

Fig. 9b

26-2

26-3

26-1

Fig. 8

$B_0$

8d

10a

10c

8c

8b

10b

8a

Fig. 10

## EUROPEAN SEARCH REPORT

Europäisches Patentamt
European Patent Office
Office européen des brevets

**Application Number**

EP 21 17 6101

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X,D | US 2018/292502 A1 (ATALAR ERGIN [TR] ET AL) 11 October 2018 (2018-10-11) | 1,3,4,7, 10,12, 13,15-18 | INV.<br>G01R33/24<br>G01R33/07 |
| Y | * paragraph [0005] - paragraph [0010]; | 2,8,9,11 | G01R33/387 |
| A | figures 1,2 *<br>* paragraph [0026] - paragraph [0043] *<br>* paragraph [0059] *<br>* paragraph [0069] * | 5,6,14 | G01R33/389<br>G01R33/565<br>G01R33/58 |
| | ----- | | ADD.<br>G01R33/02 |
| Y | US 2007/170917 A1 (THOMPSON MICHAEL R [US] ET AL) 26 July 2007 (2007-07-26)<br>* paragraph [0032] - paragraph [0037] * | 2 | |
| | ----- | | |
| Y | BOTTURA L ET AL: "Field Measurements",<br>CAS - CERN ACCELERATOR SCHOOL ON SUPERCONDUCTIVITY AND CRYOGENICS FOR ACCELERATORS AND DETECTORS,,<br>8 May 2002 (2002-05-08), pages 1-34,<br>XP007918723, | 8 | |
| A | * second paragraph of section 2.3.3 * | 1-7,9-18 | |
| | ----- | | TECHNICAL FIELDS<br>SEARCHED (IPC) |
| Y | US 2011/187360 A1 (MAILE KEITH R [US] ET AL) 4 August 2011 (2011-08-04) | 9 | G01R |
| A | * paragraph [0056] * | 1-8,<br>10-18 | |
| | ----- | | |
| Y | SCHOTT C ET AL: "High accuracy magnetic field measurements with a Hall probe",<br>REVIEW OF SCIENTIFIC INSTRUMENTS, AIP, MELVILLE, NY, US,<br>vol. 70, no. 6, 1 June 1999 (1999-06-01),<br>pages 2703-2707, XP012037494,<br>ISSN: 0034-6748, DOI: 10.1063/1.1149831 | 11 | |
| A | * abstract, section III * | 1-10,<br>12-18 | |
| | ----- | | |

The present search report has been drawn up for all claims

| Place of search | Date of completion of the search | Examiner |
|---|---|---|
| Munich | 20 October 2021 | Lebar, Andrija |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 21 17 6101

This annex lists the patent family members relating to the patent documents cited in the above-mentioned European search report.
The members are as contained in the European Patent Office EDP file on
The European Patent Office is in no way liable for these particulars which are merely given for the purpose of information.

20-10-2021

| Patent document cited in search report | | Publication date | Patent family member(s) | | Publication date |
|---|---|---|---|---|---|
| US 2018292502 | A1 | 11-10-2018 | US 2018292502 A1 | | 11-10-2018 |
| | | | WO 2018186815 A1 | | 11-10-2018 |
| US 2007170917 | A1 | 26-07-2007 | NONE | | |
| US 2011187360 | A1 | 04-08-2011 | US 2011187360 A1 | | 04-08-2011 |
| | | | WO 2011097297 A1 | | 11-08-2011 |

EPO FORM P0459

For more details about this annex : see Official Journal of the European Patent Office, No. 12/82

# REFERENCES CITED IN THE DESCRIPTION

## Patent documents cited in the description

- EP 1582886 A1
- EP 2515132 A1
- EP 2708908 A1
- WO 2016184760 A1
- US 20180292502 A1
- WO 2014041147 A1

## Non-patent literature cited in the description

- **BARMET et al.** *ISMRM,* 2009, 780
- **DEZANCHE et al.** *MRM,* 2008, vol. 60, 176-186
- **SIPILÄ et al.** *ISMRM,* 2010, 781
- **DE ZANCHE N ; BARMET C ; NORDMEYER-MASSNER JA ; PRUESSMANN KP.** NMR probes for measuring magnetic fields and field dynamics in MR systems. *Magn Reson Med,* 2008, vol. 60 (1), 176-186
- **HEMANTH KS.** *Proc. IFAC,* 2012, vol. 45 (1), 175-178
- **NORRIS DG et al.** Concomitant magnetic field gradients and their effects on imaging at low magnetic field strengths. *Magn Reson Imag,* 1990, vol. 8 (1), 33-37
- **BERNSTEIN MA et al.** Concomitant gradient terms in phase contrast MR: Analysis and correction. *Magn Reson Med,* 1998, vol. 39, 300-308
- **BARON CA et al.** The effect of concomitant gradient fields on diffusion tensor imaging. *Magn Reson Med,* 2012, vol. 68, 1190
- **DE ZANCHE N et al.** NMR Probes for Measuring Magnetic Fields and Field Dynamics in MR Systems. *Magn Reson Med,* 2008, vol. 60, 176-186
- Spatiotemporal magnetic field monitoring for MR. *Magn Reson Med,* 2008, vol. 60, 187-197
- **DIETRICH BE et al.** A Field Camera for MR Sequence Monitoring and System Analysis. *Magn Reson Med,* 2016, vol. 75, 1831-1840
- Gradient Response Harvesting for Continuous System Characterization During MR Sequences. *IEEE Transactions on Medical Imaging,* March 2020, vol. 39 (3
- Minimizing the echo time in diffusion imaging using spiral readouts and a head gradient system. *Magn Reson Imag,* 2020
- **J. VANNESJO et al.** Gradient system characterization by impulse response measurements with a dynamic field camera. *Magn. Reson. Med.,* February 2013, vol. 69 (2), 583-593